# EUROPÄISCHE PATENTANMELDUNG

(11) **EP 4 250 568 A1**
(43) Veröffentlichungstag der Anmeldung: **27.09.2023**
(21) Anmeldenummer: 23163178.9
(22) Anmeldetag: 21.03.2023
(51) Int. Cl.: H03K 17/955

(54) **SENSOREINHEIT FÜR KFZ**

(30) Priorität: 22.03.2022 DE 102022010673
(71) Anmelder: Huf Hülsbeck & Fürst GmbH & Co. KG, 42551 Velbert (DE)
(72) Erfinder: ZIEGLER, Alexander, 42489 Wülfrath (DE); WEHNER, Philipp, 45879 Gelsenkirchen (DE)
(74) Vertreter: Bals & Vogel Patentanwälte PartGmbB

(57) **Zusammenfassung**

Die Erfindung betrifft eine Sensoreinheit (10) zum berührungslosen Betätigen eines Stellelementes (101), insbesondere einer Klappe (101), Tür (101) oder dergleichen eines Fahrzeuges (100), mit zumindest einem kapazitiven Sensorelement (11, 12) und einer Zuleitung (11.a, 12.a) zu jedem kapazitiven Sensorelement (11, 12), wobei die Zuleitung (11.a, 12.a) einerseits mit dem jeweiligen kapazitiven Sensorelement (11, 12) und anderseits mit wenigstens einem Stecker (15) verbunden ist, und wobei das Sensorelement (11, 12) zumindest ein Kabel (13) mit zwei zueinander isolierten Leitern (13.1, 13.2) aufweist, wobei zumindest ein Abschirmleiter (13.1) als Abschirmung für den anderen Leiter (13.2) ausgestaltet ist, und der Abschirmleiter (13.1) als Geflechts- oder Folienschirm ausgestaltet ist, und die Zuleitung (11.a, 12.a) zumindest zwei räumlich getrennte und isolierte Zuleitungsdrähte (11.a1, 2, 12.a1, 2) aufweist.

Dabei ist es erfindungsgemäß vorgesehen, dass die Zuleitungsdrähte (11.a1, 2, 12.a1, 2) zwischen Stecker (15) und Sensorelement (11, 12) zumindest abschnittsweise miteinander verdrillt sind und zumindest zwei Zuleitungsdrähte (11.a1, 2, 12.a1, 2), nämlich ein erster und zweiter Zuleitungsdraht (11.a1, 2, 12.b1, 2), galvanisch voneinander getrennt sind, wobei der erster Zuleitungsdraht (11.a1, 12.a1) elektrisch leitend mit dem Abschirmleiter (13.1) des Sensorelements (11, 12) verbunden ist und der zweiter Zuleitungsdraht (11.a2, 12.a2) nur elektrisch leitend mit dem Stecker (15) verbunden ist und bis zum Sensorelement (11, 12) geführt ist.

Ferner ist die Erfindung auch auf ein Sensorsystem (50) sowie ein Fahrzeug (100) mit einem solchen Sensorsystem (50) gerichtet.

## Beschreibung

Die vorliegende Erfindung betrifft eine Sensoreinheit gemäß der im Oberbegriff des Hauptanspruchs näher definierten Art. Ferner bezieht sich die Erfindung auf ein Sensorsystem nach Anspruch 12 sowie auf ein Fahrzeug mit einem erfindungsgemäßen Sensorsystems.

Es ist aus dem Stand der Technik bekannt, dass Sensoreinheiten zum berührungslosen Betätigen einer Tür oder Klappe eines Fahrzeuges mit kapazitiven Sensorelementen versehen sind, um so ein kontaktloses Öffnen der Tür oder Klappe zu bewirken. Dabei existieren auch sog. Kicksensoren, bei denen der Fahrer des Fahrzeuges im Heckbereich die Heckklappe z.B. durch eine Kickbewegung seines Beines oder Fußes öffnen kann. Diese Sensoreinheiten sind im Heckbereich des Fahrzeuges angeordnet, wobei die kapazitiven Sensorelemente als längliche Leiter angeordnet sind. Damit diese kapazitiven Sensoren auch elektrisch angesteuert werden können, sind entsprechende Zuleitungen notwendig. Diese Zuleitungen stellen ebenfalls ein kapazitives Element von dem jeweiligen kapazitiven Sensorelement, den sie ansteuern bzw. elektrisch verbinden dar. Folglich können durch die Zuleitungen Störungen während des Betriebes entstehen, die zu einer Fehlauslösung der gesamten Sensoreinheit führen, wodurch sich entweder die Tür oder Klappe ungewollt öffnen lässt oder bei einem berechtigten Öffnungsversuch des Fahrers die Tür oder Klappe versehentlich zu bleibt.

Andererseits können die kapazitiven Sensoren auch nicht direkt mit der Steuerungseinheit verbunden werden, da häufig ein entsprechender Platzmangel für die Steuerungseinheit vorhanden ist. Außerdem sind meistens die kapazitiven Sensorelemente deutlich starrer (mechanisch unflexibel) als die entsprechenden Zuleitungen, sodass durch die Verwendung der flexiblen Zuleitungen der Einbau der Sensoreinheit vereinfacht ist.

Aus der Offenlegungsschrift DE 10 2017 116 392 A1 ist beispielhaft eine Sensoreinheit mit zwei kapazitiven Sensoren bekannt, die auch zur Ansteuerung einer Heckklappe geeignet ist. Auch bei dieser Sensoreinheit ist das Problem, dass die Zuleitung eine zusätzliche Kapazität zum restlichen kapazitiven Sensor darstellt. Folglich können auch über die entsprechenden Zuleitungen Störeinflüsse auf die Messergebnisse der kapazitiven Sensorelemente folgen.

Es ist daher eine Aufgabe der vorliegenden Erfindung, die voranstehend beschriebenen Nachteile zumindest teilweise zu beheben. Insbesondere ist es Aufgabe der vorliegenden Erfindung, den Aufbau der Sensoreinheit sowie des Sensorsystems zu vereinfachen und die Fehlerquote im Betrieb zu verringern.

Die voranstehende Aufgabe wird gelöst durch eine Sensoreinheit mit den Merkmalen des Hauptanspruchs, ein Sensorsystem mit den Merkmalen des Anspruchs 12 sowie durch ein Fahrzeug mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Sensoreinheit beschrieben sind, selbstverständlich auch im Zusammenhang dem erfindungsgemäßen Sensorsystem sowie dem erfindungsgemäßen Fahrzeug, und jeweils umgekehrt, so dass bezüglich der Offenbarung zu den einzelnen Erfindungsaspekten stets wechselseitig Bezug genommen wird bzw. werden kann.

Die Aufgabe wird insbesondere gelöst durch eine Sensoreinheit zum berührungslosen Betätigen eines Stellelementes, insbesondere (in Form) einer Klappe, Tür oder dergleichen eines Fahrzeuges, mit zumindest einem kapazitiven Sensorelement und einer (elektrischen) Zuleitung zu jedem kapazitiven Sensorelement, wobei die Zuleitung einerseits mit dem jeweiligen kapazitiven Sensorelement und anderseits mit wenigstens einem Stecker verbunden ist. Somit wird zu jedem Sensorelement eine gesonderte Zuleitung geführt. Ferner weist das Sensorelement zumindest ein Kabel mit zwei zueinander isolierten Leitern auf, wobei zumindest ein Abschirmleiter als Abschirmung für den anderen Leiter ausgestaltet ist, und der Abschirmleiter als (Draht-)Geflechts- oder Folienschirm ausgestaltet ist, und die (elektrische) Zuleitung zumindest zwei räumlich getrennte und (zueinander) isolierte Zuleitungsdrähte aufweist. Folglich führen zumindest zwei oder genau zwei Zuleitungsdrähte zu einem (gemeint ist "1") Sensorelement. Hierbei ist vorgesehen, dass die Zuleitungsdrähte zwischen Stecker und Sensorelement zumindest abschnittsweise (oder auch vollständig) miteinander verdrillt sind und zumindest zwei Zuleitungsdrähte, nämlich ein erster und zweiter Zuleitungsdraht, galvanisch voneinander getrennt sind (weisen keine elektrische Verbindung auf). Hierbei ist (nur) der erster Zuleitungsdraht elektrisch leitend mit dem Abschirmleiter des Sensorelements verbunden und der zweiter Zuleitungsdraht ist nur elektrisch leitend mit dem Stecker verbunden und ist bis zum Sensorelement geführt, ist jedoch nicht mit dem Sensorelement verbunden. Mit anderen Worten ist das Ende des zweiten Zuleitungsdrahts kontaktfrei zum Sensorelement ausgestaltet. Dort kann das (freie oder offene) Ende des zweiten Zuleitungsdrahts elektrisch isoliert angeordnet sein.

Unter dem Begriff: Verdrillen (der Zuleitungsdrähte) ist im Sinne der Erfindung ein Verdrehen oder (gegenseitiges) Umwickeln oder ein Überkreuzen der Zuleitungsdrähte zu verstehen. Verdrillte Zuleitungsdrähten bieten gegenüber parallel geführten Zuleitungsdrähten einen besseren Schutz gegenüber elektrischen und magnetischen Störfeldern. Durch das Verdrillen der Zuleitungsdrähte können sich Beeinflussungen durch äußere (elektromagnetische) Felder größtenteils gegenseitig aufheben.

Des Weiteren ist es im Rahmen der Erfindung denkbar, dass das Kabel des Sensorelements als ein Koaxialkabel, insbesondere mit einem konzentrischen Aufbau, ausgestaltet ist. Hierbei kann das Koaxialkabel zwei zueinander isolierte (elektrische) Leiter aufweisen, nämlich den äußeren Abschirmleiter, der insbesondere nach außen mit einer Isolation umhüllt ist, und eine innere Seele, wobei vorzugsweise die Seele zum Abschirmleiter (durch eine weitere Isolation bzw. Isolationsschicht) galvanisch voneinander getrennt ist. Derartige Koaxialkabel weisen den Vorteil auf, dass sie immer noch recht (mechanisch) flexibel sind, was den Einbau der Sensorelemente am Fahrzeug erleichtert, und als Standardprodukt kostengünstig zu erwerben sind. Dabei kann der Abschirmleiter sowohl als Drahtgeflecht als auch als Folienschirm ausgestaltet sein. Üblicherweise dient der Abschirmleiter bei einem Koaxialkabel zur Abschirmung der inneren Seele. Im vorliegenden Fall jedoch stellt der Abschirmleiter das aktive Element (quasi die Elektrode) des kapazitiven Sensorelements dar. Der andere Leiter des Koaxialkabels wird durch die innere Seele realisiert, die im vorliegenden Fall kontaktlos zum Koaxialkabel ist. Damit ist die innere Seele weder mit dem Abschirmleiter noch mit der Zuleitung für das Sensorelement galvanisch verbunden.

In einer weiteren Option kann vorgesehen sein, dass der zweite Zuleitungsdraht der Zuleitung zu einem Sensorelement an einem Ende galvanisch im Stecker mit Masse verbindbar ist und am anderen Ende kontaktlos zum Sensorelement ausgestaltet ist. Mit anderen Worten ist es im Rahmen der Erfindung möglich, dass der zweite Zuleitungsdraht der Zuleitung zu einem Sensorelement als Masseleitung ausgestaltet ist und galvanisch vom Sensorelement getrennt ist. Hierdurch kann ein verbesserter Schutz gegenüber elektrischen und magnetischen Störfeldern für den ersten Zuleitungsdraht der Zuleitung zu dem Sensorelement erzielt werden. Somit wird auch erreicht, dass (elektromagnetische) Störungen im Bereich der Zuleitungen weitestgehend eliminiert werden.

Vorteilhaft ist es darüber hinaus, wenn im Rahmen der Erfindung zumindest ein Zuleitungsdraht oder sämtliche Zuleitungsdrähte der Zuleitung zu den Sensorelementen als Kabellitzen ausgestaltet sind, die eine Vielzahl von - vorzugsweise galvanisch miteinander verbundenen - Einzeldrähten aufweist, die in einer gemeinsamen Isolierhülle (quasi als eine elektrische Leitung mit gleichem Potential) angeordnet sind. Die Verwendung von Kabellitzen im Bereich der Zuleitungsdrähte kann eine erhöhte mechanische Flexibilität der Zuleitungen erreicht werden. Auch die elektromagnetische Störempfindlichkeit dieser Zuleitungsdrähte kann durch die Verwendung von Kabellitzen verbessert werden. Außerdem kann auch bei derartigen ausgestalteten Zuleitungsdrähten auf Standarddrähte bzw. Typen, wie z.B. FLY-Draht oder FLRY-Draht zurückgegriffen werden, die damit auch recht kostengünstig erhältlich sind.

Es kann im Rahmen der Erfindung vorgesehen sein, dass zumindest ein Zuleitungsdraht der Zuleitung zu den Sensorelementen einen maximalen Querschnitt von 1,0 mm², vorzugsweise einen maximalen Querschnitt von 0,5 mm² und besonders bevorzugt einen maximalen Querschnitt von 0,35 mm² aufweist. Durch den vorliegenden Aufbau der Zuleitungsdrähte kann der maximal erforderliche Querschnitt für die Drähte deutlich reduziert werden, wodurch sich Materialeinsparungen ergeben und die mechanische Flexibilität der Zuleitung verbessert werden. Außerdem kann die kapazitive Störempfindlichkeit der entsprechenden Zuleitungsdrähte verringert werden.

Optional ist es denkbar, dass die verdrillte Zuleitung zu einem Sensorelementen die Grundkapazität maximal um 2 pF bis 50 pF, vorzugsweise um 6 pF bis 30 pF und besonders bevorzugt um 10 pF bis 20 pF erhöht. Aufgrund der geringen Drahtquerschnitte von den Zuleitungsdrähten kann somit die maximale Grundkapazität der Zuleitungen deutlich reduziert werden, sodass auch die Störanfälligkeit verringert wird.

Ein weiterer Vorteil im Rahmen der Erfindung ist erzielbar, wenn die verdrillte Zuleitung zu einem Sensorelementen ein Entstörmaß von -8 dB bis -40 db, vorzugsweise von -12 dB bis -20 db für eine kritische Störfrequenz von 0,1 MHz bis 10 MHz aufweist. Die in der Praxis gelegentlich unvermeidbare Querungen der (verdrillten) Sensorzuleitungen mit dem Kabelbaum des Fahrzeuges stören, insbesondere bei Aktivitäten eines Datenbusses, wie z.B. dem LIN-Busses, nicht mehr das relevante Messwerk der Sensoreinheit. Damit lässt sich auch die Fehlerquote der gesamten Sensoreinheit entsprechend verringern.

Bevorzugt kann im Rahmen der Erfindung vorgesehen sein, dass die Zuleitung zu jedem kapazitiven Sensorelement mit genau einem einzigen Stecker verbunden sind. Hierbei kann vorzugsweise die Zuleitung selber zu dem jeweiligen kapazitiven Sensorelement überschneidungsfrei angeordnet sind. Mit anderen Worten ist hiermit gemeint, dass die Zuleitungen zu einem kapazitiven Sensorelement sich nicht mit der Zuleitung zu dem anderen kapazitiven Sensorelement überschneiden. Aufgrund der erfindungsgemäßen Anordnung der Zuleitung würde eine derartige Überschneidung jedoch kaum Störungen im Messwerk erzeugen. Um jedoch das Problem im Vorfeld auszuschließen, empfiehlt es sich derartige Überschneidungen bei den Zuleitungen zu den einzelnen Sensorelementen zu vermeiden.

Vorteilhaft ist es zudem, wenn zumindest ein Ende des Kabels des Sensorelements durch ein Dichtungselement (welches vorzugsweise Kunststoff aufweist), insbesondere in Form einer Dichtungshülse oder einer Dichtungskappe, abgedichtet ist. Auch kann das entsprechende Dichtungselement an dem entsprechenden Enden des Kabels aufgespritzt oder aufgeschrumpft oder aufgepresst ist. Durch die Verwendung der entsprechenden Dichtungselemente kann auch die Störempfindlichkeit des Sensorelements durch Feuchtigkeit oder Verschmutzung deutlich verbessert werden. Idealerweise ist an dem einen Ende des Kabels, welches mit der Zuleitung verbunden ist, eine Dichtungshülse vorgesehen, die auch eine elektrische Verbindungsstelle zwischen der Zuleitung und dem Kabel des Sensorelements abdichtet, und an dem anderen Ende des Kabels, welches quasi offen ausgestaltet ist, die Dichtungskappe. Die beiden Dichtungselemente können, nachdem das Kabel des Sensorelementes mit der Zuleitung elektrisch verbunden ist, im Kunststoffspritzverfahren aufgespritzt werden oder als Schrumpfmaterial aus Kunststoff (thermisch) aufgeschrumpft werden. Auch können die entsprechenden Dichtelemente thermoplastisch aufgepresst oder rein mechanisch verpresst werden. Hierbei können auch mehrkomponentige Dichtungselemente zum Einsatz kommen, die bspw. eine Metall- und Gummi-/Silikonkombination aufweisen. Die Dichtungselemente können stoff- und/oder kraft-und/oder formschlüssig die Enden des Kabels abdichten.

In einer weiteren Möglichkeit kann vorgesehen sein, dass eine elektrische Verbindungsstelle zwischen der Zuleitung und dem Kabel des Sensorelements, insbesondere zwischen dem ersten Zuleitungsdraht und dem Abschirmleiter, durch eine Crimp-Verbindung oder eine Lötverbindung vorhanden ist. Durch die genannten Verbindungen lässt sich auf einfache Art und Weise eine gute elektrische Verbindung herstellen, die - wie bereits zuvor beschrieben - idealerweise durch die Dichtungshülse abgedichtet ist.

Des Weiteren ist es im Rahmen der Erfindung optional möglich, dass die Dichtungshülse auch eine Verbindungsstelle zwischen der Zuleitung und dem Kabel des Sensorelements, insbesondere zwischen dem ersten Zuleitungsdraht und dem Abschirmleiter, abdichtet. Auch ist es denkbar, dass auch der zweite Zuleitungsdraht isoliert in der Dichtungshülse angeordnet ist. Auch wenn es nicht erforderlich ist, den zweiten Zuleitungsdraht vor Feuchtigkeit und Schmutz zu schützen, da er selber nicht in das Messwerk des kapazitiven Sensorelements eingebunden ist, empfiehlt sich trotzdem die zusätzliche Abdichtung vorzusehen, um unvorhergesehene Störungen zu vermeiden. Außerdem kann somit sichergestellt werden, dass der zweite Zuleitungsdraht um den ersten Zuleitungsdraht weiterhin geführt (verdrillt) ist, da er ansonsten mechanisch am offenen Ende fixiert werden müsste, was nun auch durch die Dichtungshülse, die idealerweise vorhanden ist, geschieht.

Ebenfalls Gegenstand der Erfindung ist ein Sensorsystem mit zumindest zwei Sensoreinheit, vorzugsweise drei bis fünf Sensoreinheiten, nach einem der vorherigen Ansprüche. Hierbei ist vorgesehen, dass eine erste Sensoreinheit im Heckbereich des Fahrzeuges anordbar ist und eine zweite Sensoreinheit im Seitenbereich des Fahrzeuges anordbar ist, und wobei vorzugsweise jede Sensoreinheit über jeweils einen Stecker mit einer Steuerungseinheit verbunden ist, die zur Auswertung der von den Sensoreinheiten gelieferten Sensorsignalen geeignet ist, und wobei die Steuerungseinheit zur Ansteuerung eines funktionswesentlichen Systems vom Fahrzeug geeignet ist. Damit bringt das erfindungsgemäße Sensorsystem die gleichen Vorteile mit sich, wie sie ausführlich mit Bezug auf die erfindungsgemäße Sensoreinheit beschrieben sind. Zudem kann das Sensorsystem geeignet sein, nicht nur die Heckklappe eines Fahrzeuges automatisch zu öffnen, sondern auch die Seitentüren und/oder die Fahrer- und Beifahrertür. Insbesondere bei Schiebetüren, die in der Regel auch elektromechanisch geöffnet werden, vereinfacht sich somit der Öffnungsvorgang.

Ein weiterer Vorteil kann im Rahmen der Erfindung erzielt werden, wenn das Sensorsystem zumindest über eine Sensorprüfeinheit verfügt, die dazu geeignet ist, zumindest ein Sensorelement auf wenigstens einen ordnungsgemäßen Anschluss oder eine ordnungsgemäße Funktionsweise zu überprüfen. Durch den Einsatz der Sensorprüfeinheit kann einerseits überprüft werden, ob die entsprechenden kapazitiven Sensorelemente ordnungsgemäß mit der Steuereinheit verbunden sind und andererseits auch die Funktionsfähigkeit des Sensorelements selber überprüft werden, falls dieses selber defekt sein sollte (z.B. durch einen Bruch oder durch äußere Einflüsse, wie Feuchtigkeit oder dergleichen). Dabei kann die Sensorprüfeinheit anhand einer reinen kapazitiven Messung das entsprechende kapazitive Sensorelement überprüfen, sodass nur ein Zuleitungsdraht ausreichend ist für diese Prüfung.

Ferner kann im Rahmen der Erfindung vorgesehen sein, dass das Sensorsystem zumindest über eine Datenspeichereinheit verfügt, die dazu geeignet ist, zumindest Daten von Sensorsignalen oder Zwischenwert zu speichern, um ein Bewegungsmuster eines Objekts (gemeint ist: Teil von einer Person) in einem Detektionsbereich vor den Sensorelementen erfassen und auswerten zu können. Als Objekt (gemeint ist: Teil von einer Person) wird im Sinne der Erfindung ein Arm, Hand, Bein oder Fuß oder dergleichen von einer Person verstanden, die sich dem Fahrzeug nähert bzw. Zugang zum Fahrzeug haben möchte. Als Bewegungsmuster des Objekts wird z.B. eine Schwenkbewegung oder Winkbewegung des Beins oder Arms oder dergleichen von dem Objekt bzw. der Person verstanden, die von der Sensoreinheit messtechnisch erfasst werden kann. Vorzugsweise trägt diese Person auch ein mobiles Gerät - beispielsweise in Form eines Handys oder ID-Gebers - mit sich, um eine elektronische Authentifizierung mit dem Fahrzeug vornehmen zu können. Durch den Einsatz der Datenspeichereinheit können somit auch unterschiedliche Bewegungsmuster des Objekts als zugehörige Messdaten erkannt und/oder gespeichert werden, um somit insgesamt Fehlinterpretation des Bewegungsmusters, z.B. durch ein einfaches Entlanggehen einer Person an einem Sensorelement (ohne das definierte Bewegungsmuster), zu vermeiden. Zusätzlich lassen sich auch unterschiedliche Bewegungsmuster bei dem erfindungsgemäßen Sensorsystem realisieren, da die entsprechenden Messergebnisse von den Sensoreinheiten in der Datenspeichereinheit zwischengespeichert werden können.

Ebenfalls Gegenstand der Erfindung ist ein Fahrzeug mit wenigstens einem Sensorsystem nach einem der Ansprüche 12 bis 14 und zumindest einer Sensoreinheit nach einem der Ansprüche 1 bis 11. Damit bringt das erfindungsgemäße Fahrzeug die gleichen Vorteile mit sich, wie sie ausführlich mit Bezug auf die erfindungsgemäße Sensoreinheit sowie das erfindungsgemäße Sensorsystem erläutert worden sind. Bei dem vorliegenden Fahrzeug kann insgesamt ein hoher Komfort für den Fahrer zum Öffnen und ggf. Schließen des Stellelements erzielt werden. Außerdem ist die Fehlerwahrscheinlichkeit bei der Bedienung durch die entsprechende Sensoreinheit und das entsprechende Sensorsystem deutlich reduziert.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: schematische Seitenansicht eines Fahrzeuges mit dem erfindungsgemäßen Sensorsystem mit mehreren erfindungsgemäßen Sensoreinheiten im Heckbereich sowie an den Front- und den Seitentüren des Fahrzeuges,
- Figur 2: Draufsicht auf das Fahrzeug aus Figur 1 mit Darstellungen der Detektionsbereiche für die vorhandenen Sensoreinheiten,
- Figur 3: schematische Darstellung einer Sensoreinheit mit genau einem kapazitiven Sensorelement,
- Figur 4: vergleichbare Darstellung des Sensorelements aus Figur 3, wobei jedoch insgesamt zwei Sensorelemente für die Sensoreinheit vorgesehen sind und nur ein Stecker zum Anschluss,
- Figur 5: schematischer Aufbau einer Steuerungseinheit für das erfindungsgemäße Sensorsystem und
- Figur 6: schematische Darstellung des Aufbaus eines Kabels für das Sensorelement, insbesondere in Form eines Koaxialkabels.

In den Figuren werden für die gleichen technischen Merkmale auch für unterschiedliche Ausführungsbeispiele die identischen Bezugszeichen verwendet, wodurch auch eine Kombination der Merkmale für die unterschiedlichen Ausführungsbeispiele deutlich wird.

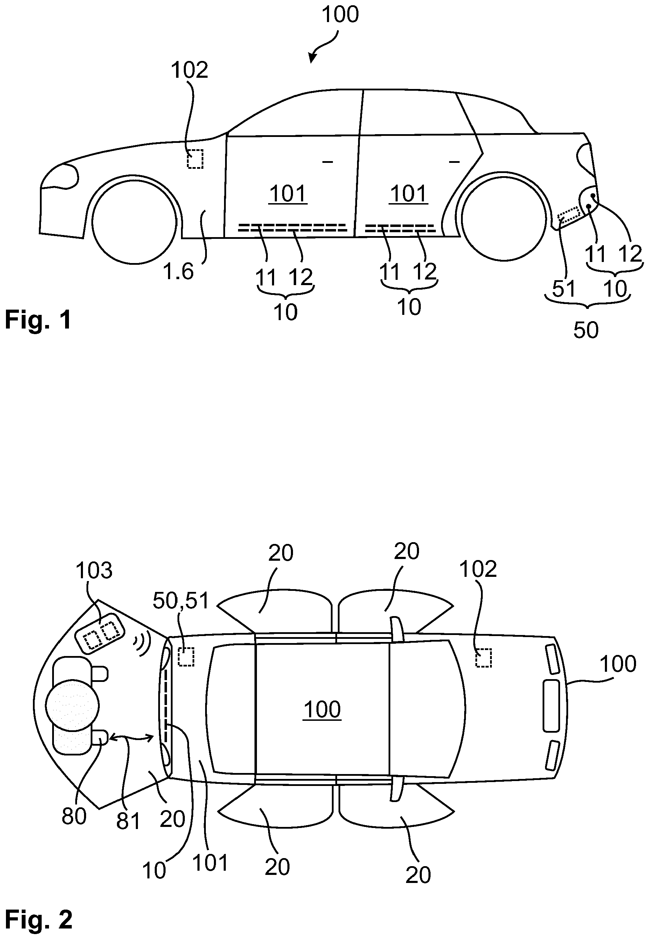

In der Figur 1 und 2 ist ein Fahrzeug 100 mit einem entsprechenden Sensorsystem 50 gezeigt. Dabei ist das Fahrzeug in der Figur 1 in der Seitenansicht gezeigt und in der Figur 2 in der Draufsicht. Wie in Figur 1 zu erkennen ist, sind im Heckbereich zwei Sensorelemente 11 und 12 in Form des Kabels 13 angeordnet, die zusammen eine Sensoreinheit 10 bilden. Diese beiden Sensorelemente 11 und 12 sind als kapazitive Sensorelemente ausgestaltet und verfügen über einen Detektionsbereich 20 (der in Figur 2 im Heckbereich dargestellt ist). Von den Sensorelementen 11 und 12 verläuft jeweils eine Zuleitung 11.a und 12.a zu einer Steuerungseinheit 51, die bspw. auch im Heckbereich des Fahrzeuges 100 angeordnet sein kann. Über diese Zuleitungen 11.a, 12.a werden die Sensoreinheiten 10 messtechnisch betrieben und bilden zusammen mit der Steuerungseinheit 51 das Sensorsystem 50.

Weiter ist aus der Figur 1 zu entnehmen, dass auch an der Fronttür 101 sowie der Beifahrertür (nicht dargestellt) eine Sensoreinheit 10 mit den beiden Sensorelementen 11, 12 vorhanden sein kann, genauso wie an den beiden links- und rechtsseitigen Hecktüren 101. Da im vorliegenden Fall das Fahrzeug 100 als ein PKW 100 ausgestaltet ist, sind die entsprechenden Stellelemente 101 als klappbare bzw. schwenkbare Türen 101 dargestellt. Anstelle der Türen 101 im Heckbereich kann auch eine Schiebetür bei z.B. einem Van oder einem Bus vorgesehen sein. Dabei ist es im Rahmen der vorliegenden Erfindung denkbar, dass sich alle Stellelemente 101 des Fahrzeuges 100 durch das erfindungsgemäße Sensorsystem 50 automatisch öffnen und ggf. verschließen lassen.

Wie aus der Figur 2 deutlicher zu erkennen ist, weisen die Sensoreinheiten 10, wobei bei dem vorliegenden Fahrzeug 100 insgesamt fünf Sensoreinheiten 10 vorgesehen sind, nämlich einen für den Heckbereich, zwei für die Hecktüren und zwei für die Fahrer- und Beifahrertür, auf, die jeweils über einen eigenen Detektionsbereiche 20 verfügen. Dabei sind die Detektionsbereiche 20 derart (räumlich) voneinander getrennt, dass es nicht zu Fehlauslösungen zwischen den einzelnen Sensoreinheiten 10 kommen kann.

Wie in der Fig. 2 weiter dargestellt, kann sich eine Person dem Fahrzeug 100 nähern, indem er in den Detektionsbereich 20 einer Sensoreinheit 10, im vorliegenden Fall dem Heckbereich, nähert. Diese Annäherung kann durch die Sensoreinheit 10 in den Detektionsbereich 20 hinter dem Heckbereich erfasst werden, um z.B. einen Weckvorgang vom Fahrzeug 100 an ein mobiles Gerät 103, z.B. in Form von einem Handy oder einem ID-Geber, welches die Person mit sich trägt, zu starten. Nachdem Weckvorgang des mobilen Gerätes 103 kann ein Authentifizierungscode zwischen dem mobilen Gerät 103 und dem Fahrzeug 100 stattfinden, um somit bspw. ein funktionswesentliches System 102 ebenfalls aufzuwecken. Bei diesem funktionswesentlichen System 102 kann es sich beispielsweise um eine Zentralverriegelung 102 oder ein Zugangssystem 102 vom Fahrzeug 100 handeln. Wenn nun die Person mit einem Fuß 80 oder Bein 80, welches als Objekt 80 kurzum bezeichnet wird, ein (vordefiniertes) Bewegungsmuster (s. Pfeil 81) in dem Detektionsbereich 20 ausübt, kann dieses von der Sensoreinheit 10 bzw. dem Sensorsystem 50 mit der dazugehörigen Steuereinheit 51 erkannt werden und z.B. einen Öffnungsvorgang der Heckklappe 101 auslösen. Dieser Vorgang funktioniert selbstverständlich auch in den Detektionsbereichen 20 von den übrigen Sensoreinheiten 10 an den Seitentüren 101 vom Fahrzeug 100.

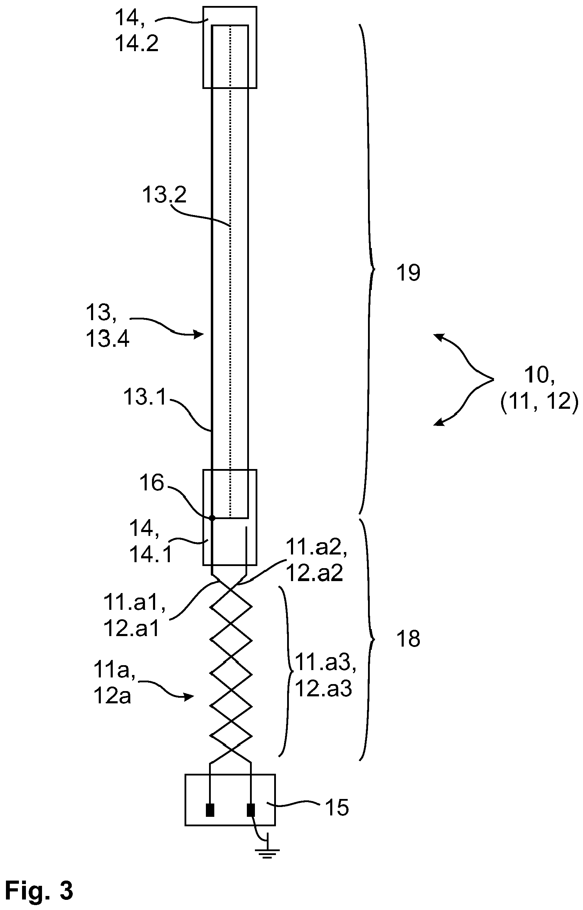

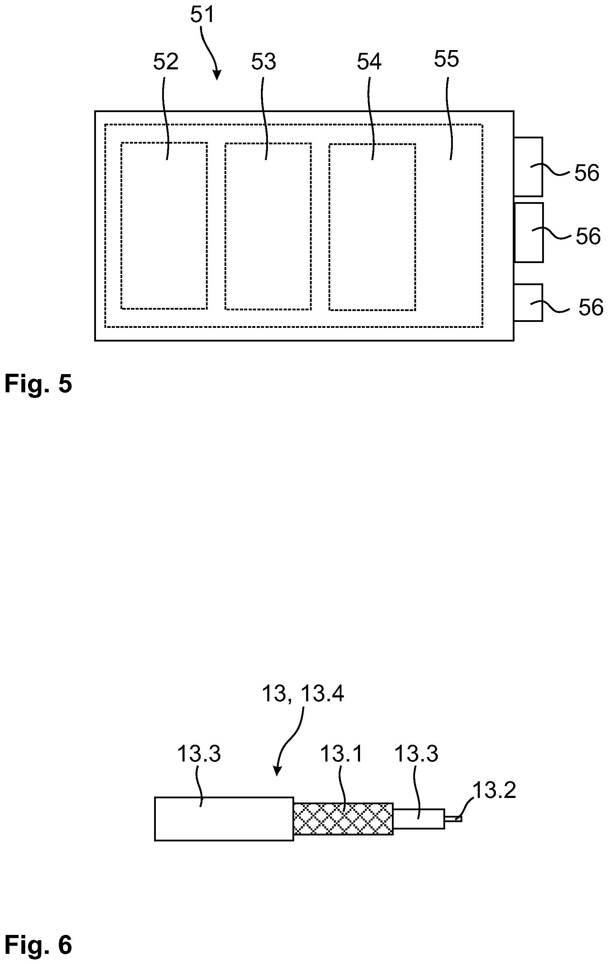

In der Figur 3 ist rein schematisch eine Sensoreinheit 10 mit genau einem Sensorelement 11 (optional jeweils das Sensorelement 12, siehe entsprechende Bezugszeichen 12.a) dargestellt. Zur besseren Übersicht wurde auf eine Darstellung der üblicherweise vorhandenen elektrischen Isolation der Drähte und Kabel verzichtet, wie sie nur in der Figur 6 abgebildet ist.

Wie in Figur 3 abgebildet ist, wird der kapazitive Sensor, in Form des Kabels 13, welches insbesondere als Koaxialkabel 13.4 ausgestaltet ist, über eine Zuleitung 11.a (optional 12.a) mit dem Stecker 15 elektrisch leitend verbunden, um somit die gesamte Sensoreinheit 10 mit der Steuerungseinheit 51 des Sensorsystems 50 elektrisch leitend verbinden zu können. Das Kabel 13 stellt dabei den eigentlichen (kapazitiven) Sensorbereich 19 des Sensorelements 11 (oder 12) dar. In der Figur 6 ist das Kabel 13 in seinem Aufbau näher beschrieben.

Wie bereits zuvor erläutert, wird als Kabel 13 vorzugsweise ein Koaxialkabel 13.4 mit einem Abschirmleiter 13.1 und einem weiteren Leiter 13.2, in Form einer (inneren) Seele 13.2 verwendet, siehe Figur 3. Dabei ist der Abschirmleiter 13.1 elektrisch bzw. galvanisch von dem weiteren Leiter 13.2 bzw. der Seele 13.2 getrennt. Um nun das Kabel 13 mit dem Stecker 15 elektrisch zu verbinden, ist die entsprechende Zuleitung 11.a (oder 12.a) vorgesehen. Diese Zuleitung 11.a weist zumindest zwei Zuleitungsdrähte 11.a1, 11.a2 auf. Ferner ist der erste Zuleitungsdraht 11.a1 elektrisch leitend mit dem Abschirmleiter 13.1 des Kabels 13 verbunden. Der zweite Zuleitungsdraht 11.a2 hingegen ist nur elektrisch leitend mit dem Stecker 15 verbunden und am anderen Ende, welches ebenfalls zum Kabel 13 geführt wird, ist es offen, also kontaktlos, insbesondere zum Kabel 13, ausgestaltet. Somit weist der zweite Zuleitungsdraht 11.a2 keinen elektrisch leitenden Kontakt zum kapazitiven Sensorbereich 19 des Kabels 13 auf. Um jedoch die Zuleitung 11.a vor elektromagnetischen Störfeldern zu schützen, sind die Zuleitungsdrähte 11.a1 und 11.a2 miteinander verdrillt. Dabei ist die Verdrillung 11.a3 zumindest abschnittsweise oder auch vollständig der beiden Zuleitungsdrähte 11.a1, 11.a2 zwischen dem Stecker 15 und dem ersten Ende vom Kabel 13 vorgesehen. Dieses erste Ende (des Kabels 13) kann mit einem Dichtelement 14, insbesondere in Form einer Dichtungshülse 14.1 abgedichtet werden.

Um eine elektrische Verbindung zwischen der Zuleitung 11.a und dem Kabel 13 herzustellen, ist eine (elektromechanische) Verbindungsstelle 16 vorgesehen. Diese Verbindungsstelle 16 stellt eine elektrische Verbindung zwischen dem ersten Zuleitungsdraht 11.a1 und dem Abschirmleiter 13.1 her. Der zweite Zuleitungsdraht 11.a2 wird elektrisch nicht mit dem Kabel 13, insbesondere mit seinen Leitern, verbunden. Vielmehr kann das offene kontaktlose Ende des zweiten Zuleitungsdrahts 11.a2 ebenfalls durch die Dichtungshülse 14.1 elektrisch isoliert am ersten Ende des Kabels 13 angeordnet werden. Somit dient die Dichtungshülse 14.1 nicht nur als Isolation für die Zuleitung 11.a1 sondern gleichzeitig auch als mechanisches Fixierelement für die beiden Zuleitungsdrähte 11.a1 und 11.a2, wodurch der Zuleitungsbereich 18 und die Verdrillung 11.a3 gesichert werden kann.

Am entgegengesetzten Ende (vom ersten Ende des Kabels 13 mit der Verbindungsstelle 16) ist das weitere Ende des Kabels 13, welches ebenfalls offen ausgestaltet ist. Wie bereits beschrieben, sind die beiden Leiter 13.1, 13.2 des Kabels 13 nicht miteinander elektrisch leitend verbunden. Um somit auch das weitere, zweite Ende des Kabels 13 gegen äußere Einflüsse zu schützen, kann dieses ebenfalls mit einem Dichtungselement 14, insbesondere in Form einer Dichtungskappe 14.2 versehen sein. Die beiden zuvor erwähnten Dichtungselemente 14 können Kunststoff aufweisen und durch einen Spritzgussverfahren oder durch ein thermisches Aufschrumpfen auf die Enden des Kabels 13 aufgebracht werden.

Vorzugsweise ist zumindest der zweite Zuleitungsdraht 11.a2 (oder 12.a2) im Stecker 15 mit Masse verbunden, sodass er einen sog. Masseleiter darstellt.

In der Figur 3 wurde vorwiegend ausschließlich das Sensorelement 11 mit der entsprechenden Zuleitung 11.a beschrieben, wobei dieses auch als Sensorelement 12 mit der entsprechenden Zuleitung 12.a ausgestaltet sein kann.

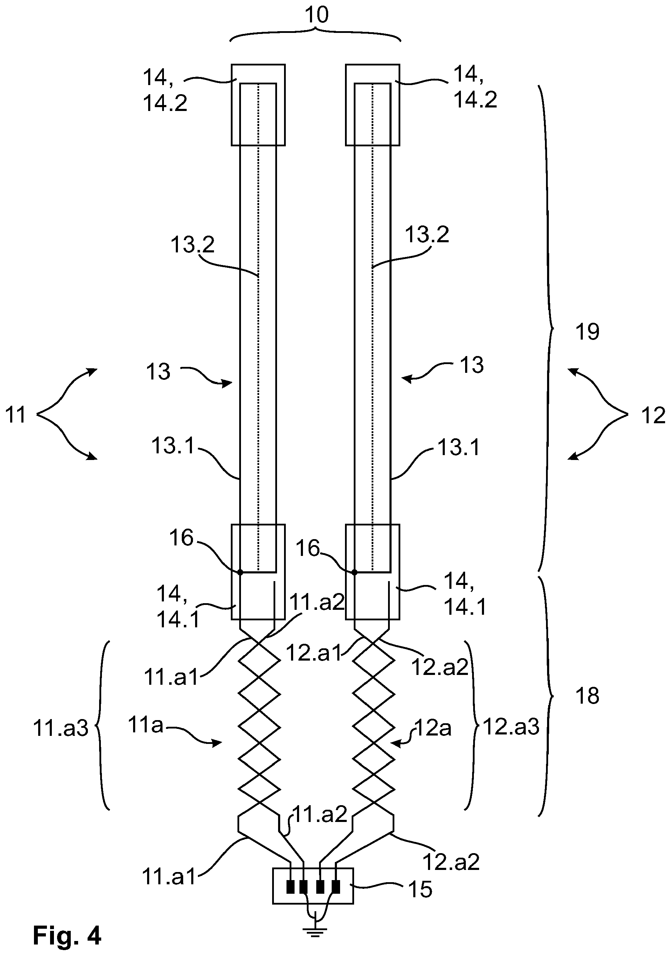

In der Figur 4 ist nun eine Sensoreinheit 10 mit zwei Sensorelementen 11 und 12 dargestellt. Die beiden Sensorelemente 11 und 12 sind baugleich ausgestaltet und entsprechen dem Aufbau des Sensorelements 11 aus Figur 3. Besonders ist jedoch, dass beide Sensorelemente 11, 12 der Sensoreinheit 10 mit nur einem Stecker 15 mit der Steuereinheit 51 verbunden werden können. Hierdurch lässt sich der Montageaufwand des gesamten Sensorsystem 50 weiter reduzieren. Der Stecker 15 kann mit einer Steckerbuchse 56 mit dem Sensorsystem 50 verbunden werden. Idealerweise ist die Steckverbindung des Steckers 15 und der Steckerbuchse 56 feuchtigkeitsdicht ausgestaltet und verfügt über eine Rastverbindung, damit sie sich bei Vibration und mechanischen Störeinflüssen nicht selbstständig losrappeln kann. Idealerweise können die beiden Sensorelemente 11 und 12 mit einer Masseleitung, in Form der zweiten Zuleitungsdrähte 11.a2, 12.a2 versehen sein. Auch ist es denkbar, dass jedes Sensorelement 11, 12 über einen eigenen Stecker 15 mit dem Sensorsystem 50 verbunden werden könnte.

In der Figur 5 ist rein schematisch die bereits erwähnte Steuerungseinheit 51 des Sensorsystems 50 dargestellt. Um einen besonders einfachen und kompakten Aufbau zu erzielen, weist diese eine Leiterplatte 55 auf, an der verschiedene elektrische Einheiten, wie z.B. die Steuerungseinheit 51, eine Sensorprüfeinheit 52, eine Datenspeichereinheit 53 sowie ein Microcontroller 54 vorhanden sein können, die über Leiterbahnen der Leiterplatte 55 miteinander elektrisch leitend verbunden sind. Ferner wird das Sensorsystem 50 über Steckerbuchsen 56 mit den vorhandenen Sensoreinheiten 10 bzw. deren Steckern 15 verbunden. Des Weiteren wird das Sensorsystem 50 auch über eine (Spannungs-) Versorgungsleitung und vorzugsweise einen Daten-Bus (wie z.B. LIN-Bus) mit der Fahrzeugelektronik (über einen entsprechenden Stecker 56) verbunden. In der Figur 5 sind insgesamt zwei Steckerbuchsen 56 dargestellt die jedoch auch optional durch drei oder vier Steckerbuchsen 56 ergänzt werden können, je nach Anzahl der vorhandenen Sensoreinheiten 10.

In der Figur 6 ist schematisch der Aufbau des Kabels 13 dargestellt. Dieses Kabel ist in Form eines Koaxialkabels 13.4 ausgestaltet und weist die innere Seele 13.2 (als weiteren Leiter 13.2) auf. Um die innere Seele 13.2 elektrisch von dem Abschirmleiter 13.1 zu entkoppeln, ist eine Umhüllung in Form der (elektrischen) Isolation 13.3 vorgesehen. Auf dieser Isolation 13.3 kann dann der Abschirmleiter 13.1, mit einem Geflechtsschirm und/oder einem (zusätzlichen) Folienschirm ausgestaltet sein. Der Abschirmleiter 13.1 selber wird nochmals von einer (äußeren) Isolation 13.3 umhüllt bzw. umgeben, damit auch der Abschirmleiter 13.1 elektrisch isoliert werden kann. Im Rahmen der vorliegenden Erfindung wird der Abschirmleiter 13.1 über die Verbindungsstelle 16, welche als Crimpverbindung oder Lötverbindung zum ersten Zuleitungsdraht 11.a1 (oder 12.a1) ausgestaltet ist, miteinander verbunden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Sensoreinheit
- 11: Sensorelement
- 11.a: Zuleitung für 11
- 11.a1: erster Zuleitungsdraht
- 11.a2: zweiter Zuleitungsdraht
- 11.a3: Verdrillung von 11.a
- 12: Sensorelement
- 12.a: Zuleitung für 12
- 12.a1: erster Zuleitungsdraht
- 12.a2: zweiter Zuleitungsdraht
- 12.a3: Verdrillung von 12.a
- 13: Kabel
- 13.1: Abschirmleiter
- 13.2: weiterer Leiter / Seele
- 13.3: Isolation
- 13.4: Koaxialkabel
- 14: Dichtungselement
- 14.1: Dichtungshülse
- 14.2: Dichtungskappe
- 15: Stecker
- 16: Verbindungsstelle zwischen Zuleitung und Abschirmleiter
- 18: Zuleitungsbereich
- 19: Sensorbereich
- 20: Detektionsbereich

- 50: Sensorsystem
- 51: Steuerungseinheit
- 52: Sensorprüfeinheit
- 53: Datenspeichereinheit
- 54: Mikrocontroller
- 55: Leiterplatte
- 56: Steckerbuchse

- 80: Objekt / Teil einer Person, z.B. Fuß oder Bein
- 81: Pfeil für Bewegungsmuster

- 100: Fahrzeug
- 101: Stellelement, insbesondere Klappe oder Tür
- 102: funktionswesentliches System
- 103: mobiles Gerät / ID-Geber

## Patentansprüche

1. Sensoreinheit (10) zum berührungslosen Betätigen eines Stellelementes (101), insbesondere einer Klappe (101), Tür (101) oder dergleichen eines Fahrzeuges (100), mit zumindest einem kapazitiven Sensorelement (11, 12) und
einer Zuleitung (11.a, 12.a) zu jedem kapazitiven Sensorelement (11, 12),
wobei die Zuleitung (11.a, 12.a) einerseits mit dem jeweiligen kapazitiven Sensorelement (11, 12) und anderseits mit wenigstens einem Stecker (15) verbunden ist, und
wobei das Sensorelement (11, 12) zumindest ein Kabel (13) mit zwei zueinander isolierten Leitern (13.1, 13.2) aufweist, wobei zumindest ein Abschirmleiter (13.1) als Abschirmung für den anderen Leiter (13.2) ausgestaltet ist, und
der Abschirmleiter (13.1) als Geflechts- oder Folienschirm ausgestaltet ist, und
die Zuleitung (11.a, 12.a) zumindest zwei räumlich getrennte und isolierte Zuleitungsdrähte (11.a1, 2, 12.a1, 2) aufweist,
**dadurch gekennzeichnet,**
**dass** die Zuleitungsdrähte (11.a1, 2, 12.a1, 2) zwischen Stecker (15) und Sensorelement (11, 12) zumindest abschnittsweise miteinander verdrillt sind und zumindest zwei Zuleitungsdrähte (11.a1, 2, 12.a1, 2), nämlich ein erster und zweiter Zuleitungsdraht (11.a1, 2, 12.b1, 2), galvanisch voneinander getrennt sind,
wobei der erster Zuleitungsdraht (11.a1, 12.a1) elektrisch leitend mit dem Abschirmleiter (13.1) des Sensorelements (11, 12) verbunden ist und
der zweiter Zuleitungsdraht (11.a2, 12.a2) nur elektrisch leitend mit dem Stecker (15) verbunden ist und bis zum Sensorelement (11, 12) geführt ist.

2. Sensoreinheit (10) nach Anspruch 1,
**dadurch gekennzeichnet,**
**dass** das Kabel (13) des Sensorelements (11, 12) als ein Koaxialkabel (13.4), insbesondere mit einem konzentrischen Aufbau, ausgestaltet ist,
wobei insbesondere das Koaxialkabel zwei zueinander isolierte Leiter (13.1, 13.2) aufweist, nämlich den äußeren Abschirmleiter (13.1), der insbesondere nach außen mit einer Isolation (13.3) umhüllt ist, und eine innere Seele (13.2),
wobei vorzugsweise die Seele (13.2) zum Abschirmleiter (13.1) galvanisch voneinander getrennt ist.

3. Sensoreinheit (10) nach einem der vorherigen Ansprüche,
**dadurch gekennzeichnet,**
**dass** der zweite Zuleitungsdraht der Zuleitung zu einem Sensorelement (11, 12) an einem Ende galvanisch im Stecker mit Masse verbindbar ist und am anderen Ende kontaktlos zum Sensorelement (11, 12) ausgestaltet ist,
und/oder dass der zweite Zuleitungsdraht der Zuleitung zu einem Sensorelement (11, 12) als Masseleitung ausgestaltet ist und galvanisch vom Sensorelement (11, 12) getrennt ist.

4. Sensoreinheit (10) nach einem der vorherigen Ansprüche,
**dadurch gekennzeichnet,**
**dass** zumindest ein Zuleitungsdraht oder sämtliche Zuleitungsdrähte der Zuleitung zu den Sensorelementen (11, 12) als Kabellitzen ausgestaltet sind, die eine Vielzahl von - vorzugsweise galvanisch miteinander verbundenen - Einzeldrähten aufweist, die in einer gemeinsamen Isolierhülle angeordnet sind.

5. Sensoreinheit (10) nach einem der vorherigen Ansprüche,
**dadurch gekennzeichnet,**
**dass** zumindest ein Zuleitungsdraht der Zuleitung zu den Sensorelementen (11, 12) einen maximalen Querschnitt von 1 mm², vorzugsweise einen maximalen Querschnitt von 0,5 mm² und besonders bevorzugt einen maximalen Querschnitt von 0,35 mm² aufweist.

6. Sensoreinheit (10) nach einem der vorherigen Ansprüche,
**dadurch gekennzeichnet,**
**dass** die verdrillte Zuleitung zu einem Sensorelementen (11, 12) die Grundkapazität maximal um 2 pF bis 50 pF, vorzugsweise um 6 pF bis 30 pF und besonders bevorzugt um 10 pF bis 20 pF erhöht.

7. Sensoreinheit (10) nach einem der vorherigen Ansprüche,
**dadurch gekennzeichnet,**
**dass** die verdrillte Zuleitung zu einem Sensorelementen (11, 12) ein Entstörmaß von -8 dB bis -40 db, vorzugsweise von -12 dB bis -20 db für eine kritische Störfrequenz von 0,1 MHz bis 10 MHz aufweist.

8. Sensoreinheit (10) nach einem der vorherigen Ansprüche,
**dadurch gekennzeichnet,**
**dass** die Zuleitung (11.a, 12.b) zu jedem kapazitiven Sensorelement (11, 12) mit genau einem einzigen Stecker (15) verbunden sind, und
wobei vorzugsweise die Zuleitung (11.a, 12.b) selber zu dem jeweiligen kapazitiven Sensorelement (11, 12) überschneidungsfrei angeordnet sind.

9. Sensoreinheit (10) nach einem der vorherigen Ansprüche,
**dadurch gekennzeichnet,**
**dass** zumindest ein Ende des Kabels (13) des Sensorelements (11, 12) durch ein Dichtungselement (14), insbesondere in Form einer Dichtungshülse (14.1) oder einer Dichtungskappe (14.2), abgedichtet ist,
wobei insbesondere das Dichtungselement (14) an den entsprechenden Enden des Kabels (13) aufgespritzt oder aufgeschrumpft oder aufgepresst ist.

10. Sensoreinheit (10) nach einem der vorherigen Ansprüche,
**dadurch gekennzeichnet,**
**dass** eine elektrische Verbindungsstelle (16) zwischen der Zuleitung (11.a, 12.b) und dem Kabel (13) des Sensorelements (11, 12), insbesondere zwischen dem ersten Zuleitungsdraht (11.a1, 12.a1) und dem Abschirmleiter (13.1), durch eine Crimp-Verbindung oder eine Lötverbindung vorhanden ist.

11. Sensoreinheit (10) nach einem der vorherigen Ansprüche,
**dadurch gekennzeichnet,**
**dass** die Dichtungshülse (14.1) auch eine Verbindungsstelle (16) zwischen der Zuleitung (11.a, 12.b) und dem Kabel (13) des Sensorelements (11, 12), insbesondere zwischen dem ersten Zuleitungsdraht (11.a1, 12.a1) und dem Abschirmleiter (13.1), abdichtet,
wobei vorzugsweise auch der zweite Zuleitungsdraht (11.a2, 12.a2) isoliert in der Dichtungshülse (14.1) angeordnet ist.

12. Sensorsystem (50) mit zumindest zwei Sensoreinheit (10) nach einem der vorherigen Ansprüche,
wobei eine erste Sensoreinheit (10.1) im Heckbereich des Fahrzeuges (100) anordbar ist und eine zweite Sensoreinheit (10.2) im Seitenbereich des Fahrzeuges (100) anordbar ist, und
wobei vorzugsweise jede Sensoreinheit (10) über jeweils einen Stecker (15) mit einer Steuerungseinheit (51) verbunden ist, die zur Auswertung der von den Sensoreinheiten (10) gelieferten Sensorsignalen geeignet ist, und
wobei die Steuerungseinheit (51) zur Ansteuerung eines funktionswesentlichen Systems (102) vom Fahrzeug (100) geeignet ist.

13. Sensorsystem (50) nach einem der vorherigen Ansprüche,
**dadurch gekennzeichnet,**
**dass** das Sensorsystem (50) zumindest über eine Sensorprüfeinheit (52) verfügt, die dazu geeignet ist, zumindest ein Sensorelement (11, 12) auf wenigstens einen ordnungsgemäßen Anschluss oder eine ordnungsgemäße Funktionsweise zu überprüfen.

14. Sensorsystem (50) nach einem der vorherigen Ansprüche,
**dadurch gekennzeichnet,**
**dass** das Sensorsystem (50) zumindest über eine Datenspeichereinheit (53) verfügt, die dazu geeignet ist, zumindest Daten von Sensorsignalen oder Zwischenwert zu speichern,
um ein Bewegungsmuster (81) eines Objekts (80) in einem Detektionsbereich (20) vor den Sensorelementen (11, 12) erfassen und auswerten zu können.

15. Fahrzeug (100) mit wenigstens einem Sensorsystem (50) nach einem der Ansprüche 12 bis 14 und zumindest einer Sensoreinheit (10) nach einem der Ansprüche 1 bis 11.
